# EUROPEAN PATENT SPECIFICATION

(11) **EP 0 206 669 B1**
(45) Date of publication and mention of the grant of the patent: **19.08.1998**
(21) Application number: 86304526.6
(22) Date of filing: 12.06.1986
(51) Int. Cl.: C09J 5/02, B32B 7/12, G03C 1/91, G11B 5/62

(54) **Aziridine-treated articles**
Mit Aziridin behandelte Gegenstände
Objets traités à l'aziridine

(30) Priority: 14.06.1985 US 745261
(43) Date of publication of application: 30.12.1986
(73) Proprietor: MINNESOTA MINING AND MANUFACTURING COMPANY, St. Paul, Minnesota 55133-3427 (US)
(72) Inventor: Canty, George c/o Minnesota Mining and, P.O. Box 33427 St. Paul Minnesota 55133 (US); Jones, Robert E. c/o Minnesota Mining and, P.O. Box 33427 St. Paul Minnesota 55133 (US)
(74) Representative: Baillie, Iain Cameron

(56) References cited:
- US-A- 3 704 167
- US-A- 4 220 471
- US-A- 4 241 169
- US-A- 4 418 164
- US-A- 4 490 505

## Description

The present invention concerns the treatment of organic and inorganic surfaces. More specifically it concerns articles which have a surface that has been treated so as to improve the adhesion of various subsequently applied materials, particularly articles having two or more rigid layers attached to one another by the modified surface.

Many techniques have been employed to treat surfaces for the purpose of improving the adhesion of various subsequently applied materials to form composite articles. Such articles include magnetic recording tapes and discs, abrasive laminates, flexible printing plates, printing label stock, adhesive tapes, photographic film and the like. Composite articles having two or more rigid layers joined together form a subclass of articles which are particularly difficult to make because of the difficulty in obtaining adequate adhesion between the layers.

Previously suggested techniques have not been completely satisfactory. Such techniques include subjecting surfaces to high energy (e.g., corona discharge, electron beam discharge, flame treatment and the like). Alternatively, chemical treatments such as modifying the surfaces by chemical etching and applying primer layers have been used. Such techniques require the use of expensive equipment and may expose the operator to high energy radiation or dangerous chemicals.

Parachlorophenol has been used as one chemical surface treatment. This approach provides only minimal improvement in adhesion compared to the present invention and suffers from the major disadvantage that it is hazardous to human health.

Application of primers has also been less than satisfactory. Often the substrate surface must be treated in some way (e.g., subjected to high energy) in order that the primer will exhibit sufficient adhesion to it. Also, primers frequently must be compounded to meet the needs of a specific coating or class of such coatings.

Yet another approach is to incorporate aziridine-containing materials into functional coatings which contain groups reactive with the aziridine functionality. These coatings are then applied to a substrate. See, for example, U.S. Patent Nos. 3,017,280; 4,167,414; 4,181,528; and 4,241,169.

These references disclose that the substrate and the functional coatings must each contain groups reactive with the aziridine group so that the aziridine essentially acts as a tie layer to better anchor the functional coatings to the substrate through crosslinking reactions. They also generally disclose that substrates which do not inherently contain the requisite surface functionality to react with the aziridine (i.e., inert materials) must undergo prior modification by oxidative treatment to incorporate that functionality. Such substrates include, for example, conventional polyesters such as poly(ethylene terephthalate), conventional polyolefin films such as polyethylene, polypropylene and polystyrene.

U.S. Patent 3,704,167 discloses the use of polyazirdine-functional materials to improve the adhesion of a subsequently applied magnetic recording layer to an antihalation layer on motion picture (i.e., cinema) film, so that the magnetic recording layer is not washed off during development of the motion picture film.

U.S. Patent No. 4,418,164 discloses ccating aramid filaments with polyfunctional aziridines. The coated filaments are used as reinforcing fibers in unsaturated polyester matrices wherein they are totally encased in the matrices.

The present invention overcomes the disadvantages of the prior art and is directed to articles having at least one surface, most commonly an essentially flat surface, which has been treated with an aziridine-containing composition. In one embodiment of the invention the aziridine-containing composition consists essentially of a compound having at least one aziridine functionality. Such compositions are essentially free of any other elements of essential significance to the treatment composition.

The present invention is directed to a flat sheet one surface of which has been aziridine-modified by the product resulting from the direct interaction between said surface of said sheet and a composition comprising an aziridine-containing compound having the formula 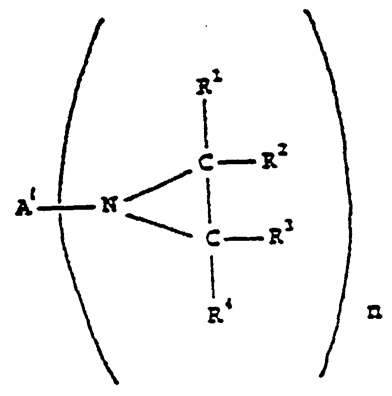 wherein A¹ is an n-valent organic or inorganic group; R¹, R², R³, R⁴ are independently selected from hydrogen and lower alkyl groups, and n is a whole number of at least 1 so as to render said surface of said sheet more adherent to subsequently applied layers, wherein said surface is not a surface of an alkali soluble antihalation layer.

The present invention is also directed to processes for adhering two or more layers to one another. In the process the surface of a first layer is treated with aziridine-containing treatment; the treated surface is then dried; and a second layer is applied to the treated surface of the first layer.

The articles and process of the invention are particularly useful when it is desired to adhere rigid layers together. As it is used herein, the term "rigid layer" refers to materials that have a modulus of elasticity either in flexure or in tension of at least 70 MPa at 23°C and 50% relative humidity when tested in accordance with ASTM Method D747 (1985 Annual Book of ASTM Standards). Within this definition, materials having a modulus of from 70 to 700 MPa are considered to have moderate rigidity while those having a modulus above 700 MPa are considered to have high rigidity.

In another embodiment of the invention the treatment composition contains an aziridine-functional material and an organic resin in a relationship such that there is at least 0.1 part of the resin present for each part of the aziridine-functional material.

Surprisingly the improvements achieved with the present invention are achieved on a wide variety of surfaces, including both inorganic and organic surfaces including metals, glass, ceramics and polymers. These surfaces include normally inert materials such as polyesters and polyolefins. Equally surprising is the fact that the improvement is achieved even if the surface has not undergone oxidative pre-treatment.

The articles of the invention have the highly desirable characteristic that a variety of subsequently applied functional materials adhere well to the modified surface. Such functional materials include magnetic recording medium (e.g., particulate materials in a binder), abrasive layers (e.g., particulate abrasive materials in a binder), printable polymer layers, gelatin and other layers used in photographic film, adhesive coatings (e.g., pressure sensitive, heat activated, solvent activated, etc.), radiation sensitive compositions (e.g., diazo systems, photo-reactive polymers, etc.) silane coatings, reinforcing polymer backings, etc.

The present invention is useful in the manufacture of stretched surface recording discs. These discs, which comprise a thin polymer film attached to a rigid support, have previously been made using an actinic radiation curable adhesive to adhere the two together. When the present invention is employed, the force holding the polymer film to the rigid support has been found to be dramatically increased.

The articles of the invention have at least one essentially flat surface and are sheet-like articles such as tapes, ribbons, films, discs, and the like. Sheet-like materials may have opposed parallel surfaces and are generally substantially thinner than they are either wide or long. However, also included in this definition are articles which are substantially thicker and which need not have opposed parallel surfaces.

The articles of the invention demonstrate excellent room temperature shelf stability as there is no measurable reduction in their ability to anchor subsequently applied coatings even though the articles have been stored for extended periods of time.

The aziridine-containing compounds useful in the invention include any compound containing at least one aziridine functionality, and preferably 2 or more aziridine functionalities.

The aziridine-containing compound may also contain other functional groups. Preferably these groups are not reactive with the aziridine functionality under ambient conditions. Thus, for example, the aziridine-functional compound may also contain one or more hydroxyl groups.

The aziridine-functional compounds useful in the present invention may be represented by the formula 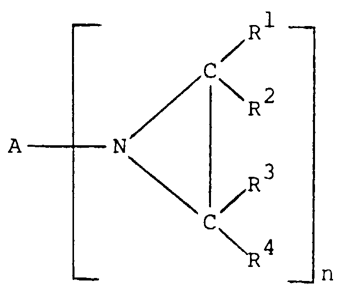 wherein A is an n valent organic or inorganic group, n is a whole number of at least one (preferably 2 to 4), and R¹, R², R³ and R⁴ may be the same or different and are individually selected from the group consisting of hydrogen and lower alkyl (branched or straight chain) groups containing from 1 to 8 (preferably from 1 to 4) carbon atoms.

The nitrogen atom of the aziridine group is preferably linked to an atom having a valence of 4 or 5 (most preferably C or P). Preferably, R¹, R² and R³ are each hydrogen and R⁴ is selected from hydrogen and alkyl containing from 1 to 4 (most preferably 1 to 2) carbon atoms.

"A" may be an aliphatic, aromatic or alicyclic organic radical which may contain atoms such as oxygen, sulfur, nitrogen, etc. A may also be an inorganic radical, such as 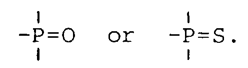 "A" preferably is 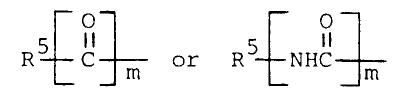 or 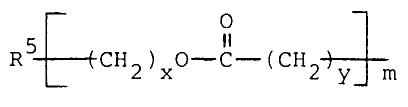 where R⁵ is an m-valent aliphatic, aromatic or alicyclic radical which may contain atoms other than carbon, e.g., oxygen, nitrogen or sulfur, m is a whole number of at least 1, and x and y are individually 0, 1 or 2.

Specific examples of useful aziridine-containing materials include
A. "CX-100" available from Polyvinyl Chemical Industries and believed to have the formula 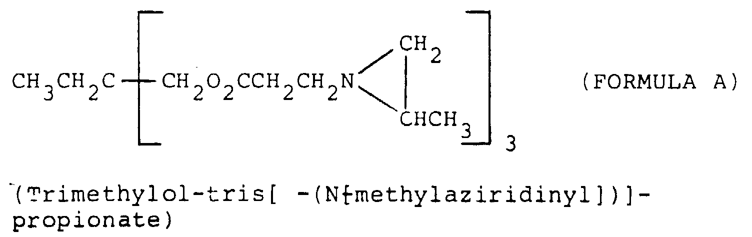
B. "XAMA-7" available from Cordova Chemical Company and believed to be a mixture of 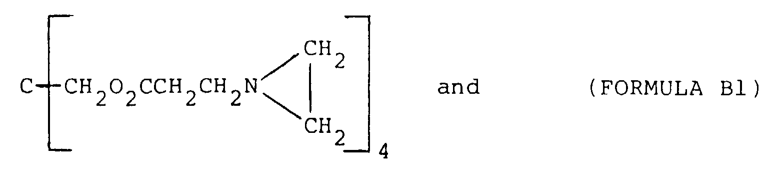 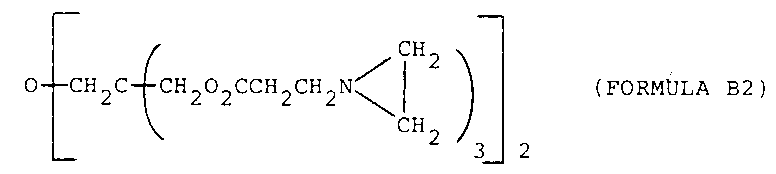
C. 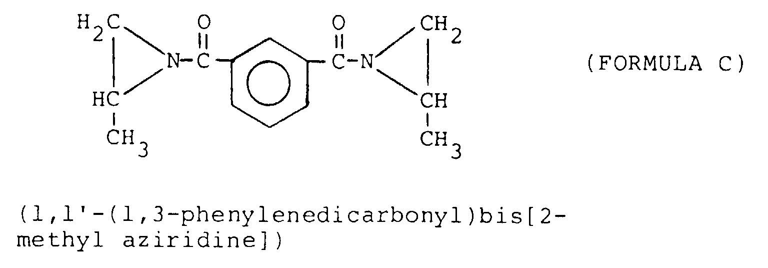
D. 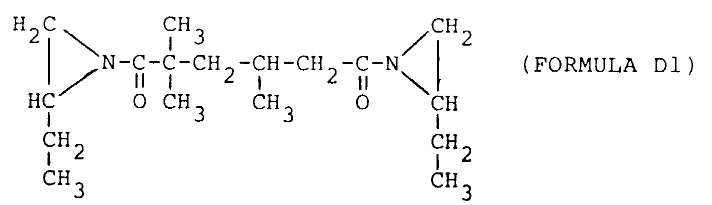 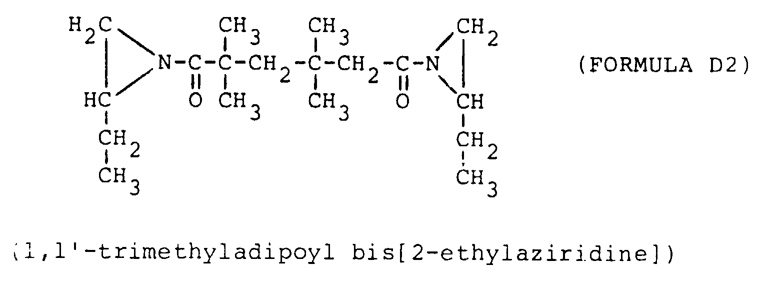
E. 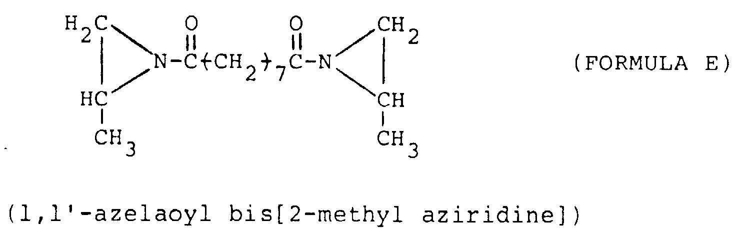
F. 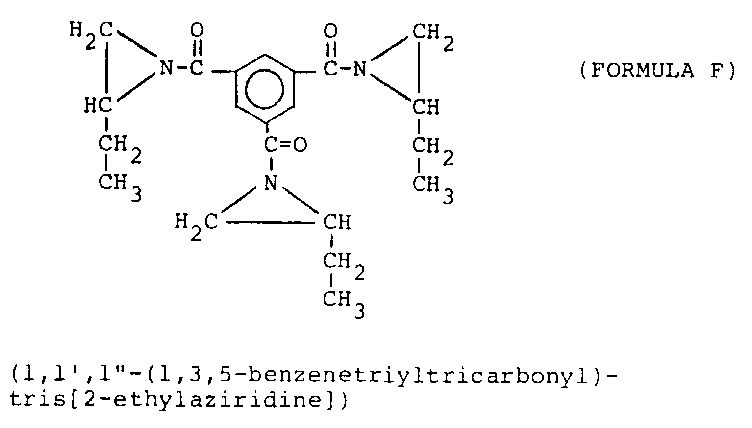
G. 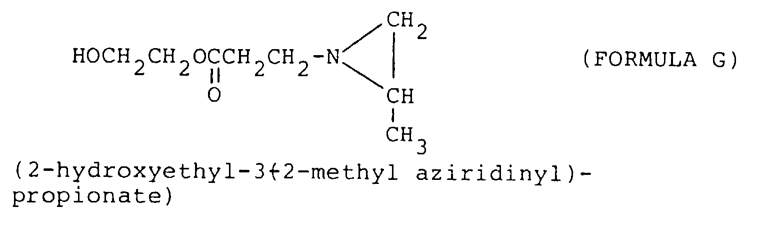
H. 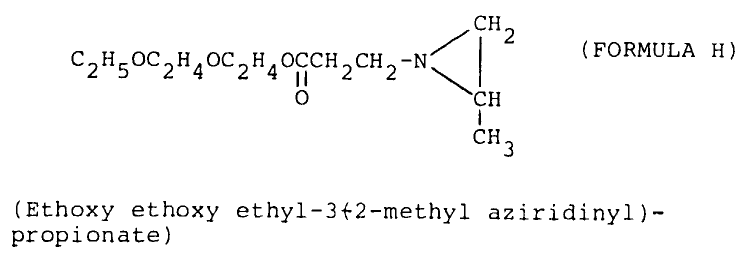
I.

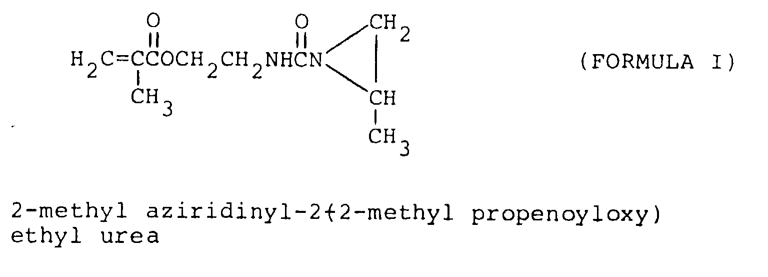

The amount of aziridine-containing material needed to provide the modified surface must be sufficient to permit interaction between the aziridine and the surface to be modified. The interaction may be the chemical reaction between the aziridine group(s) and functional groups present at the surface, mechanical interlocking between fissures or openings in the surface and the aziridine-containing material, or entrainment of the aziridine-containing group in the treated surface. Entrainment may occur by swelling of the surface due to contact with either a solvent or the aziridine-containing material followed by subsequent penetration of the aziridine-containing material into the surface to be treated. Combinations of these interactions may also occur.

Organic resins useful in the treatment composition are essentially amorphous (i.e., non-crystalline) and include vinyl resins such as polyvinyl chloride, copolymers of vinyl chloride and vinyl acetate (e.g., VYHH, VAGH, and VMCH from Union Carbide), cellulose acetate butyrate, cellulose acetate propionate and cellulose acetate. Other useful resins include ethyl, methyl and butyl methacrylate homopolymers and copolymers of said homopolymers with methyl, ethyl and butyl acrylate (e.g., the Acrysol® and Acryloid® series of resins from Rohm and Haas), urethane polymers such as the polyester-functional urethanes (e.g., the Estane® series of resins from B. F. Goodrich), polyester and polyether-functional aliphatic urethane resins (e.g., the QI and PE series of resins from Quin), urethane emulsions such as the polyester-urea urethanes (e.g., the Witco® series of resins from Witco Chemical Company, the Spensol® series from Spenser Kellogg Co., and the Neo-Rez series from Polyvinyl Chem. Ind.), linear polyester resins (e.g., the Vitel series of resins from Goodyear), and sulfo-polyesters such as those disclosed in U.S. Patent 4,480,085, U.S. 4,330,588, U.S. 4,052,368, U.S. 4,300,580, U.S. 4,304,901 and U.S. 4,525,141 at col. 2, line 66 - col. 3, line 15 and col. 4, line 29 - col. 5, line 68. If sulfopolyesters are employed it is most preferred that they be amorphous and soluble in water and/or organic solvent.

Most preferably, the organic resins are selected from nonionic and anionic organic resins. The nonionic resins are those which are essentially free from groups which impart a net ionic charge to the polymer. The anionic resins are those which contain pendant anionic groups or groups which induce a net anionic or negative charge to the polymer.

As noted, both organic and inorganic surfaces can be modified in the practice of the invention. Examples of organic surfaces include polyesters (e.g., saturated and unsaturated, linear and branched) such as poly(ethylene terephthalate), poly(l,4-cyclohexylenedimethylene terephthalate), poly(ethylene naphthalate), polymers of maleic anhydride and ethylene glycol, polymers prepared from ethylenically unsaturated monomers such as polyethylene, polypropylene, polymethylmethacrylate, polyvinyl fluoride, polyvinylidene fluoride, polystyrene, polyvinyl chloride, polyvinyl acetate, polymethylmethacrylate, copolymers of ethylene and acrylic acid, copolymers of ethylene and vinyl acetate, polycarbonates such as the Lexan™ series of materials available from General Electric, polyimides such as the Kapton™ series of materials available from DuPont, polyamides such as the Dartek™ series of nylon materials available from DuPont, cellulose acetates, polydimethylsiloxanes and the like. Oriented and unoriented organic surfaces may be used in the practice of the invention.

Examples of useful inorganic surfaces include metals (such as aluminum, copper, etc.), glass and ceramic.

The layer provided by the aziridine treatment may be continuous, intermittent, smooth, rough, textured, etc. Moreover, it may vary in thickness if desired.

The thickness of the treatment is not critical to the present invention and consequently may vary over a wide range.

Normally, suitable adhesion promotion is achieved if the aziridine treatment provides a layer at least 0.005 microns (µ) thick. The layer may be as much as 5µ thick, although no advantage has been noted at thicknesses of greater than 5µ. Preferably this layer is from 0.01 to 5µ thick and most preferably from 0.02 to 0.5µ thick.

Treatment may be easily accomplished. For example, the surface to be treated is first preferably cleaned to remove dirt and grease using known cleaning techniques. The surface is then contacted with the treatment composition using a variety of techniques such as brushing, spraying, roll coating, curtain coating, knife coating, etc., and then processed at a time for a temperature so as to cause interaction between the surface and the aziridine group(s) and dry the treatment composition on the surface.

A wide range of processing temperatures may be used. The particular temperature employed must be sufficient to permit interaction between the aziridine-containing compound and the substrate but not so high as to degrade either the surface being treated or the aziridine functionality. Typical processing temperatures range from 15 to 250°C. Preferably the treated surface is processed at a temperature of from 70 to 140°C.

The resulting coating comprises a thin dry, preferably solvent-resistant layer on the surface of the substrate. This layer is most preferably insoluble in common solvents for the substrate. Thus, for example, after being formed on a polyester surface, the layer cannot be dissolved in common solvents for polyester such as trifluoroacetic acid.

By appropriate selection of the coating composition and processing conditions the intermediate layer can be rendered insoluble in common solvents for the substrate. Thus, for example, after being formed on a polyester surface, the layer cannot be dissolved in common solvents for polyester such as trifluoroacetic acid.

For example, an insoluble intermediate layer results when the coating composition is applied to unoriented polyester film followed by biaxial orientation and heat setting using known techniques.

The treatment composition may comprise either the aziridine compound alone, a water or solvent solution or dispersion of the aziridine, or a solution or dispersion of the aziridine and organic resin. When a solution or dispersion is used which is free from organic resin, the treatment composition typically comprises from 0.01 to 15 (and preferably from 0.2 to 1) percent by weight of the aziridine.

When the organic resin is employed in connection with the aziridine, there is at least 0.1 part by weight of organic resin to 1 part of aziridine material. Preferably there are from 0.2 to 80 parts of organic material present per part of the aziridine material. Preferably there are from 0.2 to 80 parts of organic material present per part of the aziridine material. Most preferably there are from 0.67 to 4 parts of organic material per part of aziridine material.

Examples of organic solvents useful in the treatment compositions include acetone, dichloroethane, butyl cellosolve, methyl ethyl ketone, toluene, heptane, xylene, ethyl acetate, etc.

If water is employed as the liquid vehicle, it is preferred that a surfactant material also be included in the treatment composition. The surfactant may comprise up to 2.5 times the weight of the aziridine component in the treatment composition. Anionic, cationic, non-ionic, or amphoteric surfactant materials may be employed. Examples of useful surfactants include octylphenoxy polyethoxy ethanol, alkylaryl polyethersulfonates, ethoxylated fluorochemical alcohols, fluoroaliphatic polyesters, etc.

In certain instances it has been found that surfaces treated with a composition comprising water, aziridine and optionally surfactant is textured, i.e., it has clusters of pronounced surface irregularities separated from one another by areas of smooth surface. The clusters, which may be seen as projections from a replicated surface when viewed under 32,000X magnification using a transmission electron micrograph, are not present when an organic solvent is used as the liquid vehicle.

While the treatment composition employed in the present invention contains the aziridine compound, and optionally an organic resin, it is permissible to employ other ingredients such as binders (at up to 50 weight percent of the treatment composition), slip agents, colorants (e.g., dyes and pigments), antioxidants, UV light stabilizers, (at up to 5 weight percent of the composition), surfactants and the like. These ingredients are essentially non-reactive with the aziridine under normal conditions, that is they do not react with the aziridine functionality. If reactive ingredients are employed, they must be present in insignificant amounts so that they do not prevent interaction between the substrate surface and the aziridine group.

The articles of the invention are uniquely suited to being prepared by continuous in-line manufacturing processes. The treatment composition may be applied to either unoriented, partially oriented, or fully oriented webs. Treated unoriented or partially oriented webs may be further oriented if desired. Conventional orientation conditions may be used in such processes. Thus, the web may be stretched in the lengthwise direction by known techniques and subsequently stretched in the crosswise direction using known techniques. Alternatively, biaxially stretched in both directions at the same time.

A particularly useful manufacturing process comprises the steps of stretching the web in the lengthwise direction at 80-95°C, applying the treatment composition to the uniaxially oriented web, stretching the treated, uniaxially oriented web at 100-120°C in the crosswise direction, and then heat setting the biaxially oriented web at 200-250°C. Typically webs are oriented by being stretched to from 1 to 5 times their original dimension wherein the length to width stretch ratio may vary from 1:1 to 1:5 and from 5:1 to 1:1. Other stretch ratios may be used if desired.

This technique is particularly useful when the composition is applied to a previously length oriented polyester film followed by width orientation and heat setting. In this process the treatment layer tends to be a little thicker (e.g., from 0.1 to 0.4 microns thick) than if the treatment composition has been applied to the film before any orientation.

After the surface has been treated, a layer of functional material may be applied thereto using known techniques. The phrase "functional material" means any material subsequently applied to the treated surface. These materials include, as noted above, a magnetic recording medium, an adhesive, a radiation sensitive composition, a silane coating, a metal layer, etc. The functional layer is attached at an interface which has been modified by interaction between the surface and the aziridine-containing compound. The functional layer may be smooth, rough textured, continuous, intermittent the the like. Moreover, it may vary in thickness if desired.

The present invention will be further explained by reference to the following examples wherein all percents are percents by weight unless otherwise specified. These examples serve to further illustrate the present invention and do not limit it.

### EXAMPLES 1-12

A treatment composition containing "CX-100" available from Polyvinyl Chemical Industries and fluid media (Acetone) was prepared by combining the ingredients in a suitable mixing vessel and stirring them at 20°C until the mixture was uniform. The treatment composition was then applied to the substrates using Meyer bar coating and dried in an air circulating oven to provide treated layers having various thicknesses.

The inorganic substrates were first scrubbed with a concentrated detergent solution using a camel hair brush, rinsed thoroughly in warm tap water, rinsed with deionized water, then dried overnight at room temperature before being treated.

A functional magnetizable coating was applied over the aziridine-treated surface and dried to provide a layer about 3µm (microns) thick. The magnetizable coating comprised 66 weight percent acicular iron oxide particles having an average length of 0.6 micrometer and an aspect ratio of 8:1. The binder comprised polyurethane elastomer, phenoxy resin and other ingredients substantially as described in the comparative example of U.S. Patent No. 4,210,703.

The functional coating was applied using a Meyer rod and dried in a forced air oven at 71°C for one minute followed by 82°C for one minute. The coated substrates were then aged for five days at room temperature and then tested for adhesion using the following scrape adhesion test.

The sample to be tested was fastened to a flat, solid, surface with the functional coating being exposed. A "BIC" disposable razor was placed on the coating such that the blade contacted the coating. While applying a force on the razor normal to the coating in excess of 5 kg. the razor was pushed away from the tester at a rate of 10-20 cm/min. The adhesion of the coating to the substrate was observed and rated as follows:

| RATING | OBSERVATION |
|---|---|
| Excellent | 100% retention of coating on modified surface |
| Good | 90-100% retention of coating on modified surface. |
| Fair | 75-90% retention of coating on modified surface. |
| Poor | Less than 75% retention of coating on modified surface. |

The treatment conditions and results are set forth in Table 1.

**TABLE 1**

| EX.No | SUBSTRATE | DRY CONDITIONS (TEMP(°C)/TIME(Min)) | | TREATMENT LAYER THICKNESS (µ) | ADHESION RATING |
|---|---|---|---|---|---|
| . | | 1ST STAGE | 2ND STAGE | | |
| 1 | Polyester (biaxially oriented) | 74/1 | 138/2 | 0.304 | Excellent |
| 2 | Polypropylene (oriented) | 74/1 | 127/2 | 0.304 | Excellent |
| 3 | Polyethylene | 74/1 | 93/2 | 0.304 | Fair |
| 4 | Polycarbonate | 74/1 | 121/2 | 0.304 | Excellent |
| 5 | Polyvinyl acetate | 74/1 | 138/2 | 0.608 | Excellent |
| 6 | Polystyrene | 74/1 | 93/2 | 0.608 | Excellent |
| 7 | Polyimide ("Kapton" from DuPont) | 74/1 | 138/2 | 0.304 | Excellent |
| 8 | Polyvinyl chloride | 74/1 | 121/2 | 0.608 | Excellent |
| 9 | Aluminum | 74/1 | 138/2 | 1.216 | Excellent |
| 10 | Copper | 74/1 | 138/2 | 1.216 | Excellent |
| 11 | Plate glass | 74/1 | 138/2 | 1.216 | Excellent |
| 12 | Ceramic tile | 74/1 | 138/2 | 0.304 | Good |

### EXAMPLES 13-22

Treatment compositions were prepared using various aziridine-functional compounds and applied to biaxially oriented poly(ethylene terephthalate) (i.e., PET) film. The aziridine employed and the adhesion results obtained are set out in Table 2.

**TABLE 2**

| EXAMPLE | AZIRIDINE FORMULA | MODIFIED SURFACE THICKNESS(µ) | ADHESION RATING |
|---|---|---|---|
| 13 | A | 0.008 | Excellent |
| 14 | A | 0.015 | Excellent |
| 15 | A | 0.031 | Excellent |
| 16 | A | 0.076 | Excellent |
| 17 | A | 0.13 | Excellent |
| 18 | A | 0.25 | Excellent |
| 19 | A | 0.5 | Excellent |
| 20 | A | 1.216 | Excellent |
| 21 | G | 1.368 | Excellent |
| 22 | F | 0.076 | Excellent |

### EXAMPLES 23-36

Treatment compositions were prepared using various aziridine-functional compounds and applied to corona treated biaxially oriented PET. The aziridine used and the adhesion results obtained are set out in Table 3.

**TABLE 3**

| EXAMPLE | AZIRIDINE FORMULA | MODIFIED SURFACE THICKNESS(µ) | ADHESION RATING |
|---|---|---|---|
| 23 | A | 2.432 | Excellent |
| 24 | C | 0.038 | Excellent |
| 25 | C | 0.076 | Excellent |
| 26 | C | 0.152 | Excellent |
| 27 | C | 0.500 | Excellent |
| 28 | D1/D2 | 0.038 | Excellent |
| 29 | D1/D2 | 0.076 | Excellent |
| 30 | D1/D2 | 0.152 | Excellent |
| 31 | D1/D2 | 0.500 | Excellent |
| 32 | E | 0.038 | Excellent |
| 33 | E | 0.076 | Excellent |
| 34 | E | 0.152 | Excellent |
| 35 | F | 0.136 | Good |
| 36 | H | 1.368 | Good |

### EXAMPLES 37-45

Treatment compositions comprising "CX-100", water and various surfactants were prepared and applied to one surface of a PET surface. The treated surfaces were dried in an air circulating oven at 74°C for 1 minute and 138°C for 2 minutes. The functional oxide coating described in Example 1 was applied to the dried surface as described in Example 1 and tested for adhesion. The results obtained are given in Table 4.

**TABLE 4**

| EX. | AZIRIDINE % | SURFACTANT | | MODIFIED SURFACE THICKNESS(µ) | ADHESION RATING |
|---|---|---|---|---|---|
| | | % | TYPE | | |
| 37 | 2.3 | 0.7 | "Triton" X-200⁽¹⁾ | 0.152 | Excellent |
| 38 | 2.3 | 0.7 | "Triton" X-200 | 0.044 | Excellent |
| 39 | 2.3 | 0.7 | "Triton" X-200 | 0.076 | Excellent |
| 40 | 2.7 | 0.3 | "FC-170"⁽²⁾ | 1.216 | Excellent |
| 41 | 2.3 | 0.7 | "FC-170" | 0.916 | Excellent |
| 42 | 2.7 | 0.3 | "FC-430"⁽³⁾ | 1.216 | Excellent |
| 43 | 2.3 | 0.7 | "FC-430" | 0.916 | Excellent |
| 44 | 2.3 | 0.7 | "Triton" X-100⁽⁴⁾ | 1.216 | Excellent |
| 45 | 2.3 | 0.7 | "Triton" X-100 | 0.916 | Excellent |

| | | | | | |
|---|---|---|---|---|---|
| (1) Sodium salt of alkaryl polyether sulfonate available from Rohm & Haas. | | | | | |
| (2) Fluorochemical surfactant available from Minnesota Mining and Manufacturing Company. | | | | | |
| (3) Fluorochemical surfctant available from Minnesota Mining and Manufacturing Company. | | | | | |
| (4) Octyl phenoxy polyethoxy ethanol available from Rohm and Haas. | | | | | |

The treated surfaces were replicated and the replications were examined under a transmission electron microscope at 32,000X. It was found that the treated surfaces comprised a discontinuous surface having clusters of surface irregularities projecting upward from the surface. Surfaces treated with organic solvent solutions of aziridines did not possess the clusters of projecting sites but comprised relatively smooth surfaces.

### EXAMPLE 46

A treatment composition containing aziridine of formula B1/B2 (4% by weight in water) was prepared. An unoriented cast PET web was oriented in the length direction at 90°C by stretching it to 3.5 times its original length. The treatment composition was applied to one surface of the uniaxially oriented web, and the treated web then oriented in the width direction at 110°C by stretching it to 3.5 times its original width. The biaxially oriented film was then heat set at 230°C The treated surface provided a layer that was 0.122 µm (microns) thick.

A functional oxide coating of the formula described in Example 1 was applied to the treated surface and dried as in Example 1. The functional coating had excellent adhesion to the substrate.

### EXAMPLES 47-51

Treatment compositions comprising 8 weight percent "CX-100", 71.4 weight percent water, 1.6 weight percent "Triton" X-100 and 19 weight percent 1N HCl were prepared and applied to one surface of an unoriented PET web and dried at 72°C for three minutes. The treated web was then conditioned for 1.5 minutes at 93°C and then biaxially oriented by stretching it 3.5 x 3.5 times at 110°C. The oriented film was then heat set at 230-245°C.

A gelatin composition comprising the following materials was then applied to the modified surface of the biaxially oriented and heat set film:

| COMPONENT | PARTS BY WEIGHT |
|---|---|
| Lana Perl Red Dye | 0.023 |
| Gelatin | 9.9 |
| Water | 92.0 |
| "Triton" X-200 | 0.01 |
| Formaldehyde (37% in water) | 0.08 |
| H₂SO₄ | 0.125 |

The gelatin was applied as a warm solution at a coating thickness of 75µm (microns). The coating was dried for four hours at 20°C and then tested for adhesion to the modified surface. The dried gelatin layer was scribed using a cross-hatch template and a thin metal tip. A section of No. 610 tape (available from Minnesota Mining and Manufacturing Company) was applied to the scribed area, pressed down and quickly removed. The quantity of gelatin retained on the modified surface was then recorded. The results are given in Table 5.

**TABLE 5**

| EXAMPLE | MODIFIED SURFACE THICKNESS (µ) | % GELATIN RETAINED |
|---|---|---|
| 47 | 0.182 | 100 |
| 48 | 0.364 | 100 |
| 49 | 0.486 | 100 |
| 50 | 0.364 | 60-80 |
| 51 | 0.046 | 0-20 |

These results show that even at aziridine-modified surface thicknesses of as low as 0.046 , there is still adhesion of the gelatin to the surface.

### EXAMPLE 52

A series of coating compositions were prepared from the following ingredients:

| | A | B | C | D | E |
|---|---|---|---|---|---|
| Sulfonated Polyester (Prep'd according to Ex. 1 of U.S. 4,330,588) | 0.8 | 0.8 | 0.8 | 0.4 | 0.12 |
| Triton X-100 (Available from Rohm and Haas Co.) | 0.2 | 0.2 | 0.2 | 0.2 | 0.05 |
| CX-100 (Trimethylol-tris [β-(N(methylazirdinyl))]-propionate available from Polyvinyl Chemical Industries) | 0.05 | 0.02 | 1 | 2.2 | 0.0625 |
| Water | 20 | 20 | 20 | 97.2 | 32.7 |

The ingredients were mixed at room temperature until a uniform dispersion was obtained and then applied to separate pieces of cast unoriented PET using meyer bar coating techniques. The coated PET films were biaxially oriented 2x2 at 90-110°C and then heat set at 230°C. A magnetizable coating having the composition of that of Example 1 was then applied over the aziridine-containina layer and dried to provide a dry layer about 3µm (microns) thick.

The functional coating was applied using a Meyer rod and then heated in a forced air oven at 71°C for one minute followed by 82°C for one minute. The coated substrates were then aged for five days at room temperature and then tested for adhesion using the scrape adhesion test. The calculated coating thickness and the adhesion results obtained are given in Table 6.

**TABLE 6**

| | A | B | C | D | E |
|---|---|---|---|---|---|
| Coating Thickness (µ) | 0.13 | 0.12 | 0.25 | 0.043 | - |
| Adhesion Results | E | E | E | E | E |

### EXAMPLE 53

Example 52 was repeated using the following coating compositions:

| | A | B |
|---|---|---|
| Water Based Urethane | | |
| (R-960 NeoRez - Polyvinyl Chemical Ind.) | 0.4 | 0.12 |
| CX-100 | 2.2 | 0.0625 |
| Triton X-100 | 0.2 | 0.05 |
| Water | 97.2 | 30.8 |

The calculated coating thickness and the adhesion results obtained are given in Table 7.

**TABLE 7**

| | A | B |
|---|---|---|
| Coating Thickness (µ) | 0.043 | - |
| Adhesion Results | E | E |

### EXAMPLE 54

The following coating compositions were prepared:

| | A | B | C | D |
|---|---|---|---|---|
| Vitel 307 (Linear Polyester from Goodyear | 0.4 | 0.4 | - | - |
| Urethane (R-960 NeoRez) | - | - | 0.12 | 0.12 |
| CX-100 | 0.04 | 0.08 | 0.0625 | 0.0625 |
| Triton X-100 | - | - | 0.5 | 0.5 |
| Methyl Ethyl Ketone | 8.2 | 8.2 | - | - |
| Toluene | 1.4 | 1.4 | - | - |
| Water | - | - | 25.7 | 25.7 |

The coatings were applied to individual pieces of biaxially oriented PET film and heated for 1 minute at 74°C and then at 121°C for 2 minutes. The thickness of each of the coatings was calculated to be 0.304µ (Samples A & B), 0.15µ (Sample C) and 0.222µ (Sample D).

A magnetizable coating was prepared and applied to the dried coating as described in Example 1. The adhesion of the magnetizable coating to each of the substrates was found to be excellent.

### EXAMPLE 55

Example 1 was repeated using the following coating compositions:

| | A | B | C |
|---|---|---|---|
| Sulfonated Polyester | 0.8 | 0.8 | 0.8 |
| TX-100 | 0.2 | 0.2 | 0.2 |
| CX-100 | 0.01 | 0.5 | 0.2 |
| Water | 29 | 29 | 29 |

The calculated thicknesses and the adhesion results are given in Table 8.

**TABLE 8**

| | A | B | C |
|---|---|---|---|
| Coating Thickness (µ) | 0.12 | 0.19 | 0.15 |
| Adhesion | E | E | E |

## Claims

1. A flat sheet one surface of which has been aziridine-modified by the product resulting from the direct interaction between said surface of said sheet and a composition comprising an aziridine-containing compound having the formula 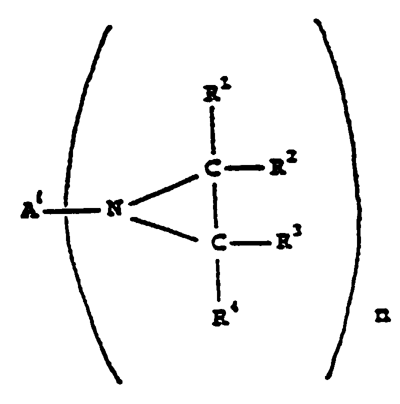 wherein A¹ is an n-valent organic or inorganic group; R¹, R², R³, R⁴ are independently selected from hydrogen and lower alkyl groups, and n is a whole number of at least 1 so as to render said surface of said sheet more adherent to subsequently applied layers, wherein said surface is not a surface of an alkali soluble antihalation layer.

2. A sheet according to claim 1 wherein said surface is not pretreated by the application of a primer layer.

3. A sheet according to claim 1 wherein said surface is not modified by oxidative pretreatment.

4. A sheet according to any preceding claim, the surface modifying composition further comprising at least 0.1 part by weight of an organic resin per part by weight of the aziridine-functional material.

5. A sheet according to claim 4 wherein said organic resin is present in an amount of from 0.2 to 80 parts by weight per part by weight of said aziridine-containing compound.

6. A sheet according to any preceding claim wherein said aziridine-modified surface is insoluble in trifluoroacetic acid at 20°C.

7. A sheet according to any preceding claim wherein said product is the result of chemical reaction between functional groups present at the surface of said sheet and the aziridine-containing material.

8. A sheet according to any one of preceding claims 1-6, wherein said product is the result of mechanical interlocking between fissures in said surface and the aziridine containing material.

9. A sheet according to any one of preceding claims 1-6 wherein said product is the result of entrainment of the aziridine-containing material in said surface.

10. A sheet according to any preceding claim wherein said sheet further comprises a functional layer on said modified surface.

11. A sheet according to claim 10, wherein said functional layer comprises a magnetic recording medium.

12. A sheet according to claim 10, wherein said functional layer comprises an adhesive.

13. A sheet according to claim 10, wherein said functional layer comprises a silane.

14. A sheet according to claim 10, wherein said functional layer comprises gelatin.

15. A sheet according to claim 10, wherein said functional layer comprises a radiation sensitive composition.

16. A sheet according to claim 10, wherein said functional layer comprises an abrasive material.

17. A sheet according to claim 10, wherein said functional layer comprises a film of a polymeric material.

18. A sheet according to any preceding claim wherein said composition comprising an aziridine consists essentially of said aziridine compound.

19. An article having at least one essentially flat major surface which has been treated with a composition comprising an aziridine-containing compound having the formula 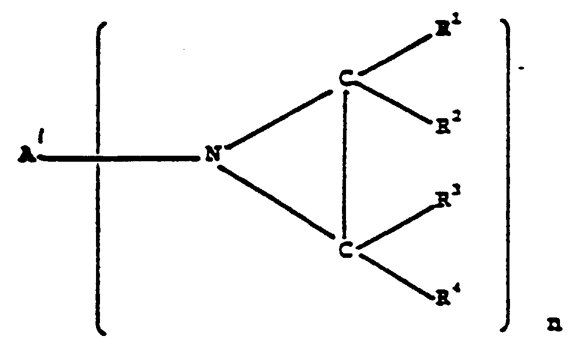 wherein A¹ is an n-valent organic or inorganic group, R¹, R², R³, R⁴ are independently selected from hydrogen and lower alkyl groups, and n is a whole number of at least 1 so as to render said surface more adherent to subsequently applied layers and further wherein said article is an inorganic material.

20. An article according to claim 19 wherein the inorganic material is selected from the group consisting of glass, metal and ceramic.

## Patentansprüche

1. Ebenes flächiges Gebilde, dessen eine Oberfläche modifiziert wurde mit Hilfe des Produktes, resultierend auf der direkten Wechselwirkung zwischen der Oberfläche des flächigen Gebildes und einer Zusammensetzung, umfassend eine Aziridin enthaltende Verbindung mit der Formel: 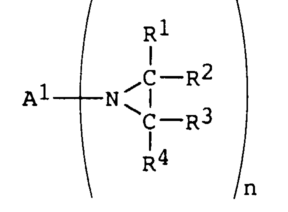 worin A¹ eine n-wertige organische oder anorganische Gruppe ist; R¹, R², R³, R⁴ werden unabhängig ausgewählt aus Wasserstoff und niederen Alkyl-Gruppen, und n ist eine ganze Zahl von mindestens 1, um die Oberfläche des flächigen Gebildes stärker haftend zu machen, wobei die Oberfläche nicht die Oberfläche einer alkalilöslichen Lichthofschutzschicht ist.

2. Flächiges Gebilde nach Anspruch 1, bei welchem die Oberfläche nicht durch die Aufbringung einer Primerschicht vorbehandelt wurde.

3. Flächiges Gebilde nach Anspruch 1, bei welchem die Oberfläche nicht durch oxidative Vorbehandlung modifiziert wurde.

4. Flächiges Gebilde nach einem der vorgenannten Ansprüche, wobei die oberflächenmodifizierende Zusammensetzung ferner mindestens 0,1 Gewichtsteile eines organischen Harzes pro Gewichtsteil des Aziridin-funktionellen Materials aufweist.

5. Flächiges Gebilde nach Anspruch 4, bei welchem das organische Harz in einer Menge von 0,2 ... 80 Gewichtsteilen der Aziridin enthaltenden Verbindung vorliegt.

6. Flächiges Gebilde nach einem der vorgenannten Ansprüche, wobei die Aziridin-modifizierte Oberfläche in Trifluoressigsäure bei 20 °C unlöslich ist.

7. Flächiges Gebilde nach einem der vorgenannten Ansprüche, wobei das Produkt das Ergebnis der chemischen Reaktion zwischen auf der Oberfläche des flächigen Gebildes vorhandenen funktionellen Gruppen und dem Aziridin enthaltenden Material ist.

8. Flächiges Gebilde nach einem der vorgenannten Ansprüche 1 bis 6, wobei das Produkt das Ergebnis des mechanischen Ineinandergreifens zwischen den Rissen in der Oberfläche und dem Aziridin enthaltenden Material ist.

9. Flächiges Gebilde nach einem der vorgenannten Ansprüche 1 bis 6, wobei das Produkt das Ergebnis des Einschleppens des Aziridin enthaltenden Materials in die Oberfläche ist.

10. Flächiges Gebilde nach einem der vorgenannten Ansprüche, wobei das flächige Gebilde ferner eine funktionelle Schicht auf der modifizierten Oberfläche aufweist.

11. Flächiges Gebilde nach Anspruch 10, bei welchem die funktionelle Schicht ein Mittel zum magnetischen Aufzeichnen aufweist.

12. Flächiges Gebilde nach Anspruch 10, bei welchem die funktionelle Schicht einen Klebstoff aufweist.

13. Flächiges Gebilde nach Anspruch 10, bei welchem die funktionelle Schicht ein Silan aufweist.

14. Flächiges Gebilde nach Anspruch 10, bei welchem die funktionelle Schicht Gelatine aufweist.

15. Flächiges Gebilde nach Anspruch 10, bei welchem die funktionelle Schicht eine auf Strahlung ansprechende Zusammensetzung aufweist.

16. Flächiges Gebilde nach Anspruch 10, bei welchem die funktionelle Schicht ein abrasives Material aufweist.

17. Flächiges Gebilde nach Anspruch 10, bei welchem die funktionelle Schicht eine Folie aus einem polymeren Material aufweist.

18. Flächiges Gebilde nach einem der vorgenannten Ansprüche, wobei die ein Aziridin aufweisende Zusammensetzung im wesentlichen aus der Aziridin-Verbindung besteht.

19. Artikel mit mindestens einer weitgehend ebenen, größeren Oberfläche, die mit einer Zusammensetzung behandelt wurde, welche Zusammensetzung eine Aziridin enthaltende Verbindung der Formel aufweist: 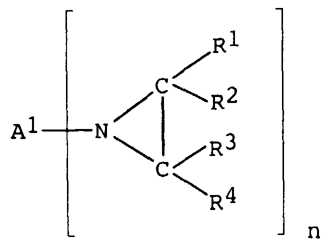 worin A¹ eine n-wertige organische oder anorganische Gruppe ist; R¹, R², R³, R⁴ werden unabhängig ausgewählt aus Wasserstoff und niederen Alkyl-Gruppen, und n ist eine ganze Zahl von mindestens 1, um die Oberfläche stärker haftend an nachfolgend aufgebrachten Schichten zu machen, und wobei der Artikel ein anorganisches Material ist.

20. Artikel nach Anspruch 19, wobei das anorganische Material ausgewählt wird aus der Gruppe, bestehend aus Glas, Metall und Keramik.

## Revendications

1. Feuille plate dont une surface a été modifiée avec de l'aziridine par le produit résultant de l'interaction directe entre ladite surface de ladite feuille et une composition comprenant un composé à fonction aziridine, de formule 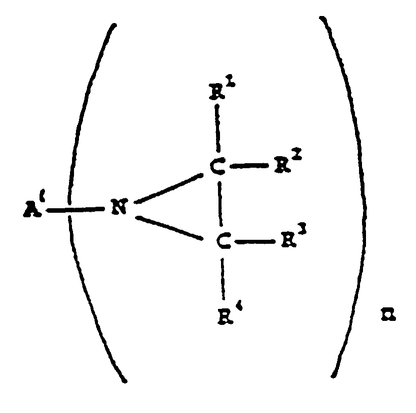 dans laquelle A¹ représente un groupe organique ou inorganique de valence n ; R¹, R², R³ et R⁴ sont choisis indépendamment entre l'hydrogène et des groupes alkyle inférieurs, et n est un nombre entier au moins égal à 1, de manière à rendre ladite surface de ladite feuille plus adhérente à des couches appliquées ultérieurement, dans laquelle ladite surface n'est pas une surface d'une couche antihalo soluble dans les substances alcalines.

2. Feuille suivant la revendication 1, dans laquelle la surface n'est pas prétraitée par application d'une couche d'apprêt.

3. Feuille selon la revendication 1, dans laquelle la surface n'est pas modifiée par un prétraitement oxydatif.

4. Feuille suivant l'une quelconque des revendications précédentes, la composition de modification de surface comprenant en outre au moins 0,1 partie en poids d'une résine organique par partie en poids de la matière à fonctionnalité aziridine.

5. Feuille suivant la revendication 4, dans laquelle la résine organique est présente en une quantité de 0,2 à 80 parties en poids par partie en poids du composé à fonction aziridine.

6. Feuille suivant l'une quelconque des revendications précédentes, dans laquelle la surface modifiée avec l'aziridine est insoluble dans l'acide trifluoracétique à 20°C.

7. Feuille suivant l'une quelconque des revendications précédentes, dans laquelle le produit est le résultat d'une réaction chimique entre des groupes fonctionnels présents à la surface de ladite feuille et la matière contenant de l'aziridine.

8. Feuille suivant l'une quelconque des revendications 1 à 6 précédentes, dans laquelle le produit est le résultat d'un enchevêtrement mécanique entre des fissures dans ladite surface et la matière contenant de l'aziridine.

9. Feuille suivant l'une quelconque des revendications 1 à 6 précédentes, dans laquelle le produit est le résultat d'un entraînement de la matière contenant de l'aziridine dans la surface.

10. Feuille suivant l'une quelconque des revendications précédentes, qui comprend en outre une couche fonctionnelle sur la surface modifiée.

11. Feuille suivant la revendication 10, dans laquelle la couche fonctionnelle comprend un support d'enregistrement magnétique.

12. Feuille suivant la revendication 10, dans laquelle la couche fonctionnelle comprend un adhésif.

13. Feuille suivant la revendication 10, dans laquelle la couche fonctionnelle comprend un silane.

14. Feuille suivant la revendication 10, dans laquelle la couche fonctionnelle comprend de la gélatine.

15. Feuille suivant la revendication 10, dans laquelle la couche fonctionnelle comprend une composition sensible aux rayonnements.

16. Feuille suivant la revendication 10, dans laquelle la couche fonctionnelle comprend une matière abrasive.

17. Feuille suivant la revendication 10, dans laquelle la couche fonctionnelle comprend un film d'une matière polymérique.

18. Feuille suivant l'une quelconque des revendications précédentes, dans laquelle la composition comprenant de l'aziridine consiste essentiellement en le composé d'aziridine.

19. Article ayant au moins une surface principale pratiquement plate qui a été traitée avec une composition comprenant un composé à fonction aziridine, de formule 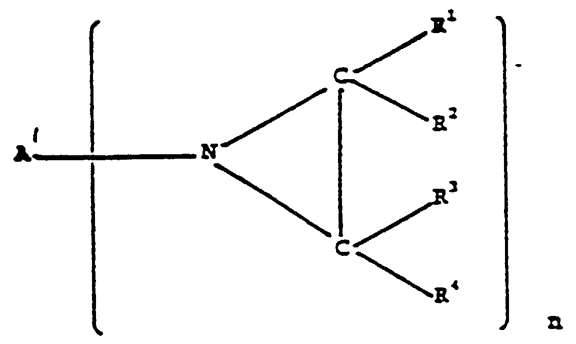 dans laquelle A¹ représente un groupe organique ou inorganique de valence n, R¹, R², R³ et R⁴ sont choisis indépendamment entre l'hydrogène et des groupes alkyle inférieurs et n est un nombre entier d'au moins un, de manière à rendre ladite surface plus adhérente à des couches appliquées ultérieurement, ledit article étant de plus une matière inorganique.

20. Article suivant la revendication 19, dans lequel la matière inorganique est choisie dans le groupe consistant en verre, un métal et une matière céramique.
